(19) Europäisches Patentamt / European Patent Office / Office européen des brevets

(11) **EP 3 425 759 A1**

(12) **EUROPEAN PATENT APPLICATION**

(43) Date of publication:
**09.01.2019 Bulletin 2019/02**

(51) Int Cl.:
***H02J 3/14*** *(2006.01)*

(21) Application number: **18181467.4**

(22) Date of filing: **03.07.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.07.2017 NL 2019163**

(71) Applicant: **Peeeks B.V.**
**2629 JD Delft (NL)**

(72) Inventors:
- **ROBERS, Egbert Wouter Joghum**
  **2629 JD Delft (NL)**
- **SMIT, Wouter**
  **2629 JD Delft (NL)**
- **LUCAS, Jorrit**
  **2629 JD Delft (NL)**
- **VAN DER HEIJDEN, Hugo Hans Julius**
  **2629 JD Delft (NL)**
- **VAN DER HEIDE, Pelle**
  **2629 JD Delft (NL)**

(74) Representative: **Patentwerk B.V.**
**P.O. Box 1514**
**5200 BN 's-Hertogenbosch (NL)**

(54) **SYSTEM FOR CONTROLLING THE ENERGY EXCHANGE BETWEEN AN ASSET AND AN ELECTRICAL GRID**

(57) The present invention relates to a system for controlling the energy exchange between an asset and an electrical grid, comprising an energy grid with at least one source of AC power and loads requiring power; the grid having a target AC frequency, and an instantaneous AC frequency, wherein the actual AC frequency is proportional to the imbalance between power supply from the at least one source and power consumption by the loads; a number of assets with a controllable power exchange with the grid, either consumption or delivery, coupled to the grid at different physical locations, a controller for each of the assets with the controllable power consumption or delivery, wherein the controllers are configured for mutual communication and to set the total power exchanged by their assets with the grid based on the difference between the desired AC frequency and the instantaneous grid AC frequency.

Fig. 2

Printed by Jouve, 75001 PARIS (FR)

**Description**

The present invention relates to a system for controlling the energy exchange between an asset and an electrical grid.

An electrical grid in itself cannot store energy. At any moment, the amount of electricity generated and put into the grid has to be equal to the amount of electricity drawn by energy consumers. If there is a shortage, that is, the grid as a whole needs more electricity than what is generated, this can lead to a dropping of voltage in the grid, also called a brown-out.

Brown-outs can damage equipment connected to the grid. Also, the whole grid or parts thereof can experience black-outs: when this occurs the energy transport comes to a full stop and the grid has to be started up completely. If there is a surplus of electricity, i.e. more electricity is generated than what is consumed, this can lead to over voltage, which can also damage equipment connected to or part of the grid. Also these over voltages can result in tripping of safeguards, creating a black out.

Keeping stability of the grid is not easy, and the complexity of this task is increasing. Not only is the amount of generators and consumers running in the millions, but many of the consumers are not under any form of control by the parties responsible for keeping the grid stable: any individual can at will switch on or off their light, water heater, computer or other appliance. On top of this, the amount of electricity consuming assets is ever increasing, and due to the prices of photovoltaic panels dropping, the amount of electricity generated out of control of utilities or grid operators is also increasing. Due to the increase in photovoltaic and wind generators driven by government incentives to promote clean energy generation the relative amount of uncontrollable generation compared to controlled generation is increasing: wind and solar is strongly depending on weather circumstances.

The US patent application US 2016 0118803 describes a system for monitoring power delivered to a grid by various assets. A central control unit sends control signals to a power control system coupled to each assed, wherein the control signal is based on measurements on the grid power.

The US patent US2426876 also describes a system for monitoring grid power values, but no central control of assets takes place.

Most countries have a national organization charged with the task to keep the national grid balanced, the national grid operator or Transmission System Operator (TSO). These grid operators use a multitude of ways to do this, such as multilateral agreements with large energy consumers like steel mills, rewards for large consumers that implement frequency-control or parties that are willing to run their emergency power generators upon the request of the grid operator.

For one form of agreement the TSO demands a contractor to react to the grid frequency. This frequency is dependent of the load balance on the grid. The generators connected to the grid experience a larger resistance, as the load on the grid is larger than was intended. This results in the generators slowing down, which in turn causes a lower frequency in the grid, as the rotational speed of these generators is tied directly to the grid's frequency. This frequency is on itself equal all across the grid and is used as a way to measure imbalance as it is directly dependent of the load put on the system.

Currently, systems that are used for this type of grid balancing are larger electricity generation units. Mostly in the form of gas fired generators. These systems are tied to frequency changes and react within a set time when the grid frequency exceeds a certain threshold. These systems have to be able to react both ways, both by raising and lowering production. In both directions they have a contracted amount of power they have to provide to or remove from the grid. The assets that participate in this primary reserve pool need to have an uptime of 100% or they face fines from the TSO.

It is a goal of the present invention to provide a system for grid balancing that takes away the need to use larger electricity generation units and in particular gas fired generators.

The invention thereto proposes a system for controlling the energy exchange between an asset and a grid, comprising an energy grid with at least one source of AC power and loads requiring power, the grid having a target AC frequency, and an instantaneous AC frequency, wherein the actual AC frequency is proportional to the imbalance between power supply from the at least one source and power consumption by the loads, a number of assets with a controllable power exchange with the grid, either consumption or delivery, coupled to the grid at different physical locations, and a controller for each of the assets with the controllable power consumption or delivery wherein the controllers are configured for mutual communication and to set the total power exchanged by their assets with the grid based on the difference between the desired AC frequency and the instantaneous grid AC frequency.

An asset is to be understood as a load coupled to the grid, and capable of exchanging power with the grid in either one direction, or both. The controllers may be configured for mutual communication directly, or indirectly, for instance via the internet or in particular via the cloud.

The assets can be grouped in different ways. The high demands to the systems that supply this reserve creates a high threshold for machines and producers that want to participate. However, it is not necessarily the case that the assets themselves need to be complicated. This is where it is necessary to be able to control assets in a very precise manner. This namely allows to combine less suitable assets with other less suitable assets to counter each other's downsides.

It is for example possible to use a group of small assets to deliver a part of this reserve. For example cogeneration installations are very suitable to deliver primary control reserve, but are on itself too small. When pooled these assets can create a very reliable and redundant supply of reserve capacity.

Furthermore, there are assets that can only react to high demand and others that can only react on low demand, in other words that can respectively ramp up or ramp down. In some grids it is mandatory to be able to react in both ways, a combination of these two assets would make them both possible to act as primary control reserve.

In another situation it is for example demanded that assets react in a linear and continuous way. Normally this would rule out assets that can only react in a discrete way, that is: being switched on or off only, without the possibility to increase or decrease a consumed or delivered power gradually. However, when combined with other assets that are able to react in a continuous way, these assets can compensate the disability of the discrete asset.

In an embodiment of the invention, the controllers are therefore further configured to set the first derivative of their total power of their loads based on the difference between the desired AC frequency and the instantaneous grid AC frequency. The first derivative forms an indicator for the speed with which the consumed or delivered power of the asset changes.

When grouped, the controllers of the assets still need to independently react to the frequency changes on the grid. The system may for that purpose comprise a central frequency meter, which may be a very accurate high end meter. The central frequency meter may for instance be configured to communicate measured frequencies together with corresponding time stamps to the controllers.

Connecting the controllers to a central control system however may involve risks of lost connections and delays between commands and implementation, in particular since in practical embodiments, the connection is not likely to be a direct connection, but will often take place via the internet, or in particular via the cloud. In order to make the assets autonomous the frequency needs to be measured at every location separately, as the assets require to have a full time access to the frequency measurement in order to perform grid balancing tasks.

Therefore, according to a preferred embodiment of the present invention, a frequency meter is be placed at every location. As frequency can be measured at every wall outlet, there are no restrictions in that area. However, frequency meters need a very accurate time base, as measuring frequencies is about counting the number of times the current switches direction per second. These clocks may become very expensive in cases in which a large number of small assets are to be used for frequency control. Accurate meters may be too expensive to be installed with every assets.

In a further embodiment the invention comprises a large group of decentralized frequency measuring devices and at least one high end frequency measurement device, connected through a central cloud. The high end frequency measurement device can be characterized as highly accurate and as a result be costly. The decentralized local frequency measurement devices may be relatively simple devices at a considerably lower cost than the central unit. Their frequency measuring accuracy can only be guaranteed when regularly gauged. In one aspect, the current invention thus proposes to create a network of low-cost frequency measurement devices gauged by a high-quality central measurement device. Since the controllers of the assets are all connected, for instance through the cloud, they may receive information from the high end frequency measurement device and use this for gauging their decentralized local frequency measurement device.

The power grid's frequency is equal throughout the whole network. Therefore, no physical nearness is required between the gauging instrument and the device being gauged. A communication channel through the internet may therefore suffice to gauge a frequency measurement device.

The current invention meets the needs created by three different energy transition effects.

First of all, frequency measurements are a necessity within the scope of the grid's primary control reserves. Such reserves are required to automatically activate when frequency deviations appear in the grid's power. Activation times are minimized by local measurements and control.

Secondly, the largest amount of potentially available control reserve is bound in small devices like home appliances. Even though such devices cannot make a significant impact on the grid by themselves, the sheer number of available devices in this category makes this the most promising group of targetable assets for flexibility services. These assets can only enter the realm of primary control when installation costs drop to an economically feasible level, since the current installation costs per device are a multitude of potential earnings.

Thirdly the invention also delivers the required frequency measurements at a local level, securing highly accurate measurements and facilitating short reaction times for device controllers. The proposed invention utilizes low-cost frequency measurement devices, opening the door for distributed frequency control over numerous small assets.

In the following, various embodiments of the invention will be described. The embodiments are exemplary only and do in no way limit the scope of protection as defined in the claims.

In a first embodiment the system according to the invention comprises a cloud based control system that sets the rules for assets to react to frequency changes in order to perform demand response tasks.

In another embodiment a similar system is designed, but local control boxes are used to control the assets. In cases where the internal control systems do not offer sufficient options to control the system and/or does not measure the frequency of the grid in a trustworthy manner where necessary

In yet another embodiment a similar system is designed, but measurement devices for frequency measurement are added to the control boxes. Those devices vary in characteristics, such as, but not limited to, high-quality devices with very accurate time bases located at fixed positions and measuring the grid frequency through a local connection to the grid and low cost frequency measurement devices with less accurate time bases. The measurements are logged to a local server and periodically uploaded to a cloud server. Some devices will be installed to control systems that have to act in certain ways dependent of the grid frequency. These local devices consist of a system and use their internal clock to determine and log the instantaneous grid frequency. Based on the measured frequency, these devices control the systems' power consumption as to meet the requirements established in the primary control agreements.

Low cost frequency measurement devices are able to generate highly accurate frequency measurements for a short amount of time. Temperature changes affect the systems' internal clocks, causing small inaccuracies in the time-keeping devices. As the internal clocks are heavily relied upon in grid frequency measurements, no inaccuracies can be tolerated in the internal clocks. To prevent drift, the build-up of errors in the internal clocks, the systems need to be gauged against the frequency measurements of other devices in order to gain reliable measurement data. This can both be done by comparing to other low cost frequency measurement devices and by comparing to the high quality frequency measurement devices in the same pool. This gauging may be performed by communication between the group that includes high-end frequency measurement device and the low cost frequency measurement devices.

The gauging can be done in a number of ways. The logged frequency measurements from the high-end device may be provided with a timestamp and transmitted to the local systems. The local systems will then compare their own measurement data to the accurate results from the high-end frequency measurement device(s) and determine its error, so that it can compensate for this error.

The logged frequency from all the devices is sent to a central server that collects the data, processes it and returns a message to the local systems in which way they should correct themselves and how their measurement is drifting from the true values. The comparison may be done based on one or more parameters such as the average frequency over a period, the frequency profile, comparison of minimum and maximum values. This effectively re-gauges the local frequency measurement device. This action is performed periodically, say hourly, to prevent the build-up of inaccuracies to cause significant errors.

Within a system as described above, frequency may be measured locally with every asset. In an embodiment, the frequency measured is checked against the instructions from a central control that direct whether that particular asset should react or not. A trigger frequency and the way the flexibility in an asset is applied changes with the pool, as every asset has a certain part of the total pool reaction to fulfil.

To give an example of how this will work in practice, a single asset, a gas powered generator spinning at a constant load of 50% of its total capacity, is considered. The generator is part of a pool of two different assets, boilers and air-conditioning. This particular generator has a very short response time and can ramp up or down quickly and maintain its load for indefinitely. It is however expensive to run, so use of the other assets is preferred. The other assets in the pool will run out of their balancing power when they have to perform a balancing action for a longer period or with high capacity; boilers are limited in warming up and cooling down as people want hot water and warming up is naturally limited, air conditioning is demanded to keep the temperature within a certain range. These assets are also fast reacting.

In the considerations the central control takes into account the reaction costs, endurance of the assets and reaction speed. Because the boilers and air conditioners can react fast, are cheap to use but are limited in their reaction time, the gas powered generator will be instructed to react after a certain integral over the time times the difference in frequency is met. This will make sure the generator takes over when the boilers and ac units run out of flexibility. The integral calculation will be done from last the point where all the assets are providing 0 flexibility and performing their normal task.

For most applications of the frequency measurement there is a specified maximum deviation from the true frequency of the grid that cannot be exceeded. Inaccuracy of devices is caused by 2 factors: drift and noise. Both of these factors are often influenced by temperature, changing component characteristics and, with them, accuracy.

As another example there may be a swarm of inaccurate frequency meters. A 5 mHz deviation on 50.000 mHz measurement mean is allowed for the system in this scenario to comply to its performance demands. The swarm of inaccurate meters is calibrated in set intervals. At every interval the system uses one of the methods of calibration to compensate the drift of the inaccurate systems by basis of the accurate system's measurements. The accurate system itself also has some drift and noise, this is a limiting factor in the total lifespan of the system. After a (long) while even the accurate system itself needs to be regauged. A mathematical equation of the way the system is controlled is given by:

> y = maximum deviation of the measurement of the inaccurate meters
> x = hours running since last calibration

a = drift in mHz/hour
b = max noise in mHz
c = noise high accuracy meter in mHz
d = drift high accuracy meter in mHz/hour
e = total hours running

$$y = (b+ax)+(de+c)$$

In practice, the following parameters may be used:

a=0.03
b=2
c=0.1
d=0.001

With a calibration every 20 hours.

The invention will now be elucidated in further detail with reference to the following figures. Herein:

-  Figures 1a-c show how a system according to the present invention sets rules for when and how the assets have to react to changes in grid frequency;
-  Figure 2 shows a system with 3 different assets and types of control systems; and
-  Figure 3 shows a graph of a maximum deviation of a frequency of a local meter against time.

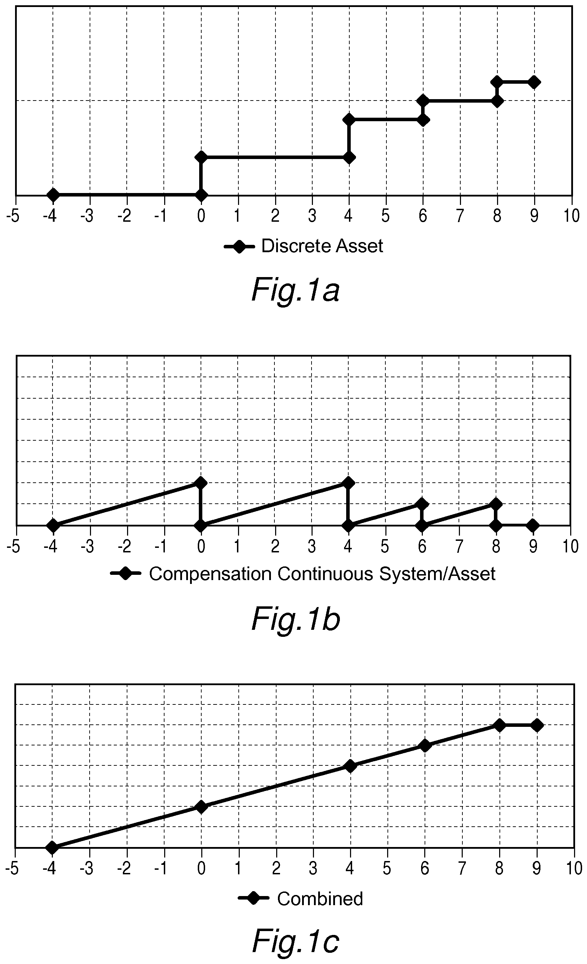

Figures 1a-c show how a system according to the present invention sets rules for when and how the assets have to react to changes in grid frequency. The system takes into account the needs for the way balancing power is delivered. To do this the system virtually pools the different assets in order to meet criteria that have basis in ramping speed, endurance of the pool's power, maximum capacity, reliability, controllability, connection stability, or cost of reacting. To comply with these sort of criteria it is necessary to make sure either all assets are perfect by themselves or compensate each other where necessary.

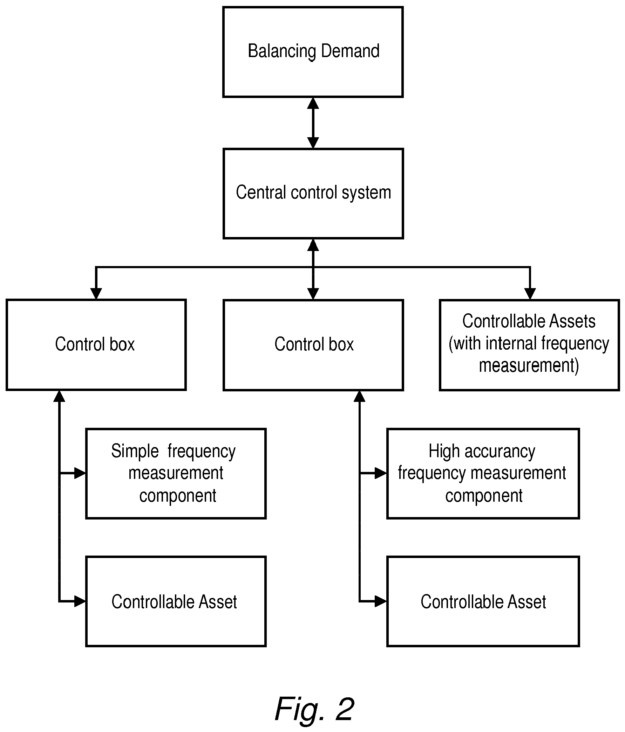

Figure 2 shows a system with 3 different assets and types of control systems. All are connected to a central control system with algorithms to determine, on the basis of capabilities of the assets and the balancing demand, how the assets need to act. Furthermore, we see different ways of frequency measurement in this figure. Communication is both ways, as the control boxes need to be controlled but they also need to provide the central control system with information on grid frequency, asset status etcetera. Next to this, the frequency needs to be gauged. Optionally, the frequency measurement devices may use a different time base. This time base is created by the use of systems that comply with the standard of IEEE 802.11. Their ability to determine whether they are themselves using the correct frequency for communication with relative high accuracy makes them suitable for use for frequency measurement of the grid. These systems rely on processors to keep the frequency measurement correct, it is therefore important to make sure the processors can dedicate their capacity to the frequency measurement by switching off other activities of the device like supplying a communication network.

It is also possible that to the frequency measurement devices a temperature sensor is added. As temperature affects the time keeping properties of quartz, with a temperature sensor every device can gauge itself against the surrounding temperature, provided it has access to the true frequency at the same time. In this way the frequency measurement devices can compensate themselves in instances when there is no connection to the rest of the network.

Alternatively or additionally, GPS receivers may be added to the devices, which creates a direct connection to the highly reliable atomic clock of GPS satellites. This timekeeping can then be used to measure the grid frequency.

It may be expected that some measurements will drift or show faults often and some will almost never show false frequency measurements. In those situations the system dedicates more gauging actions to the devices that often show faults and gauges the reliable devices less often. Furthermore, in an embodiment the measurement data of those meters that often require gauging can be ignored when determining general or average data.

It is also possible that devices make a forecast of their own drift in measurement. In that way a device can gauge itself based on its forecast. This makes the local measurement more reliable and less dependent of the pool.

In yet another embodiment a so called Kalman filter is applied over the frequency measurement. By use of this method a forecast is made of what the frequency will be and this is compared to what the measurement reads. These values are then merged and a filtered value is logged.

Furthermore it is possible to map the phase difference of the current in different locations. Phase measurement is done by comparing the offset between the AC waves. Measuring the phase of the grid in different locations can give insight in the flow direction of the current and show for example that current is going from one country to another, that a certain plant is producing electricity, or to show congestion of the grid in a local area.

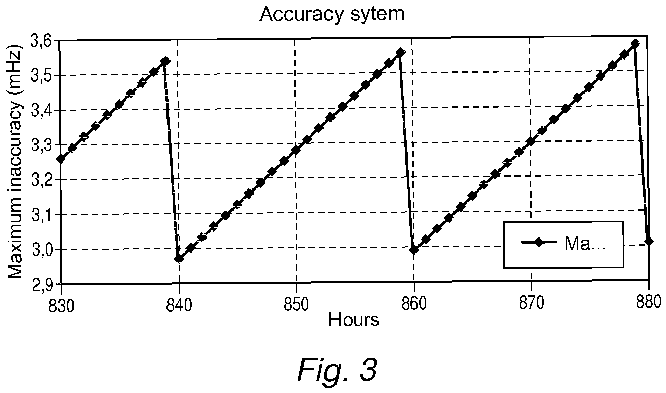

Figure 3 shows a graph of a maximum deviation of a meter against time. The course of the maximum deviation of a local frequency meter is shown against time, during the interval from 830 to 880 hours. The local frequency meter is gauged every 20 hours, but due to drifting of the central meter, the deviation may vary.

The frequency measurement devices may in an embodiment be embedded in smart meters.

**Claims**

1. System for controlling the energy exchange between an asset and an electrical grid, comprising:

    - An energy grid with at least one source of AC power and loads requiring power;

        ◦ The grid having a target AC frequency, and an instantaneous AC frequency, wherein the actual AC frequency is proportional to the imbalance between power supply from the at least one source and power consumption by the loads;
        ◦ a number of assets with a controllable power exchange with the grid, either consumption or delivery, coupled to the grid at different physical locations;
        ◦ a controller for each of the assets with the controllable power consumption or delivery;

    wherein:
    ◦ the controllers are configured for:

        ▪ mutual communication; and
        ▪ to set the total power exchanged by their assets with the grid based on the difference between the desired AC frequency and the instantaneous grid AC frequency.

2. System according to claim 1, wherein the controllers are further configured to set the first derivative of their total power of their loads based on the difference between the desired AC frequency and the instantaneous grid AC frequency.

3. System according to claim 1 or 2, comprising a central frequency meter.

4. System according to claim 3, wherein the central frequency meter communicates measured frequencies together with corresponding time stamps to the controllers.

5. System according to any of the preceding claims, wherein each of the controllers has a frequency measurement device.

6. System according to claim 4 and 5, wherein the controllers are configured to gauge their respective frequency measurement devices based on the central frequency meter.

7. System according to claim 5, wherein a logged frequency from all controllers is sent to a central server that collects the data, processes it and returns a message to the controllers in which way they should correct their frequency measurement device and/or how their measurement is drifting from the true values.

8. System according to claim 7, wherein a comparison of frequency measurement devices is done based on a comparison of one or more parameters from the group of the average frequency over a period, the frequency profile and minimum and maximum values.

9. System according to claim 7 or 8, wherein re-gauging the frequency measurement devices is performed periodically, for instance hourly, to prevent the build-up of inaccuracies to cause significant errors.

10. System according to claim 6, wherein the frequency measurement devices use a time base that complies with the standard of IEEE 802.11.

11. System according to claim 5, wherein the frequency measurement devices comprise a temperature sensor for gauging itself against the surrounding temperature.

12. System according to claim 5, wherein the frequency measurement devices comprise a GPS receiver and are configured for gauging themselves based on the atomic clock of GPS satellites.

13. System according to claim 5, wherein the frequency measurement devices are configured for applying a Kalman filter over the frequency measurement based on which a forecast is made of what the frequency will be, comparing this value to what the measurement reads and log a merged and a filtered value.

14. System according to claim 1 or 2, wherein the controllers are configured to map a phase difference of the current at different locations in the grid.

15. System according to claim 5, wherein the frequency measurement devices are embedded in smart meters.

16. Combination of a controller and a frequency measurement device for use in a system with a central frequency meter configured for communicating measured frequencies together with corresponding time stamps to the controllers, wherein the controller is configured to gauge the frequency measurement devices based on the central frequency meter.

17. System for providing local frequency information, comprising a number of combinations according to claim 16 and a central frequency meter configured to communicate a measured frequency together with corresponding time stamps to the controllers.

**18.** System according to claim 16 or 17, wherein the controllers are configured for sending a logged frequency from all controllers to a central server is configured for collecting logged frequency data, processing it and returning a message to the controllers in which way they should correct their frequency measurement device and/or how their measurement is drifting from the true values.

Fig.1a

Fig.1b

Fig.1c

*Fig. 2*

Fig. 3

Europäisches
Patentamt

European
Patent Office

Office européen
des brevets

# EUROPEAN SEARCH REPORT

Application Number

EP 18 18 1467

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/118803 A1 (TAKAHASHI JUN [JP] ET AL) 28 April 2016 (2016-04-28)<br>* paragraph [0032] - paragraph [0126]; figures 1-22 * | 1-18 | INV.<br>H02J3/14 |
| X | GB 2 426 878 A (RESPONSIVELOAD LTD [GB]) 6 December 2006 (2006-12-06)<br>* page 56, line 25 - page 64, line 2; figures 4,5 * | 1-18 | |
| A | US 2016/013676 A1 (KAJI MITSURU [JP] ET AL) 14 January 2016 (2016-01-14)<br>* paragraph [0023] - paragraph [0144]; figure 1 * | 1-18 | |
| A | US 2017/003700 A1 (PAVLOVSKI ALEXANDRE [CA] ET AL) 5 January 2017 (2017-01-05)<br>* abstract; figure 1 * | 1-18 | |

TECHNICAL FIELDS
SEARCHED    (IPC)

H02J

The present search report has been drawn up for all claims

| Place of search | Date of completion of the search | Examiner |
|---|---|---|
| Munich | 23 October 2018 | Kreutz, Joseph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 18 1467

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2018

| Patent document cited in search report | | Publication date | Patent family member(s) | | Publication date |
|---|---|---|---|---|---|
| US 2016118803 | A1 | 28-04-2016 | JP | 2016082741 A | 16-05-2016 |
| | | | US | 2016118803 A1 | 28-04-2016 |
| GB 2426878 | A | 06-12-2006 | AT | 520187 T | 15-08-2011 |
| | | | BR | PI0611013 A2 | 10-08-2010 |
| | | | CN | 101238625 A | 06-08-2008 |
| | | | DK | 1891724 T3 | 10-10-2011 |
| | | | DK | 2273648 T3 | 13-10-2014 |
| | | | EP | 1891724 A2 | 27-02-2008 |
| | | | EP | 2273647 A2 | 12-01-2011 |
| | | | EP | 2273648 A2 | 12-01-2011 |
| | | | ES | 2371355 T3 | 30-12-2011 |
| | | | GB | 2426878 A | 06-12-2006 |
| | | | GB | 2436252 A | 19-09-2007 |
| | | | GB | 2436253 A | 19-09-2007 |
| | | | JP | 5121024 B2 | 16-01-2013 |
| | | | JP | 2008543256 A | 27-11-2008 |
| | | | KR | 20080027324 A | 26-03-2008 |
| | | | MY | 140313 A | 31-12-2009 |
| | | | TW | 200705773 A | 01-02-2007 |
| | | | US | 2010072817 A1 | 25-03-2010 |
| | | | US | 2011118891 A1 | 19-05-2011 |
| | | | US | 2011190958 A1 | 04-08-2011 |
| | | | WO | 2006128709 A2 | 07-12-2006 |
| US 2016013676 | A1 | 14-01-2016 | JP | 6183727 B2 | 23-08-2017 |
| | | | JP | WO2015075758 A1 | 16-03-2017 |
| | | | SG | 11201503507R A | 30-07-2015 |
| | | | US | 2016013676 A1 | 14-01-2016 |
| | | | WO | 2015075758 A1 | 28-05-2015 |
| US 2017003700 | A1 | 05-01-2017 | AU | 2014370049 A1 | 30-06-2016 |
| | | | CA | 2933360 A1 | 02-07-2015 |
| | | | CN | 107077111 A | 18-08-2017 |
| | | | EP | 3087436 A1 | 02-11-2016 |
| | | | US | 2017003700 A1 | 05-01-2017 |
| | | | WO | 2015100256 A1 | 02-07-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160118803 A
- US 2426876 A